# EUROPEAN PATENT APPLICATION

(11) **EP 4 723 149 A2**
(43) Date of publication of application: **08.04.2026**
(21) Application number: 25205551.2
(22) Date of filing: 30.09.2025
(51) Int. Cl.: H01F 38/14

(54) **CHASSIS ASSEMBLY WITH MAGNETIC COMPONENTS**

(30) Priority: 07.10.2024 TW 113210795 U
(71) Applicant: Cooler Master Co., Ltd., Taipei City 114065 (TW)
(72) Inventor: HSU, Yuan Chang, 114065 6F., No. 398, Xinhu 1st Rd. Neihu Dist. (TW)
(74) Representative: Grünecker Patent- und Rechtsanwälte PartG mbB

(57) **Abstract**

A chassis assembly includes a first frame and a second frame movably disposed on the first frame. At least one first connector is disposed on the first frame, and at least one second connector is disposed on the second frame, the connectors being positioned between the first and second frames. At least one magnetic element is positioned between the first and second frames, and at least one electromagnet assembly is positioned between the first and second frames in correspondence with the magnetic element. The electromagnet assembly includes a magnetic conductor and a coil wound around the magnetic conductor. In an unenergized state, magnetic attraction between the magnetic element and the magnetic conductor causes the first and second connectors to mate. In an energized state, magnetic repulsion between the magnetic element and the magnetic conductor causes the first and second connectors to separate.

## Description

### TECHNICAL FIELD

The present disclosure relates to a chassis assembly, and more particularly to a chassis assembly that includes magnetic component.

### BACKGROUND

Current server system configurations arrange numerous servers in an array within a server rack. Depending on their functions, the servers may include a variety of modules such as computing modules, power supply modules, storage drives, and liquid-cooling modules. To ensure sufficient cooling for the servers within the rack, at least one coolant distribution unit is usually included.

When an operator attempts to install or remove components within the coolant distribution unit, a quick-release mechanism is typically employed to make the process easier. However, during installation or removal, the operator must exert significant force to position or disengage the internal components of the coolant distribution unit, increasing the difficulties of assembly and disassembly. Therefore, a challenge encountered by the R&D is to minimize the effort required to install and remove components within the coolant distribution unit, thereby enhancing the convenience of assembling and disassembling these units.

### SUMMARY

The invention is as as defined in the appended claims. The present disclosure is directed to a chassis assembly that allows for more effortless installation and removal of a frame. An aspect of the present disclosure provides a chassis assembly. The chassis assembly includes a first frame, a second frame movably disposed on the first frame, at least one first connector and at least one second connector respectively disposed on the first frame and the second frame and located therebetween, at least one magnetic element located between the first frame and the second frame, and at least one electromagnet assembly located between the first frame and the second frame that corresponds to the magnetic element, the electromagnet assembly having a magnetic conductor and a coil that is wound around the magnetic conductor. When the electromagnet assembly is in an unenergized state, the at least one magnetic element and the magnetic conductor attract one another to cause the first connector and the second connector to mate. When the electromagnet assembly is in an energized state, the magnetic element and the magnetic conductor repel one another to cause the first connector and the second connector to separate.

In some embodiments, the magnetic element is disposed on the first frame, and the electromagnet assembly is disposed on the second frame.

In some embodiments, the electromagnet assembly further comprises a housing and a cover plate, the housing being disposed on the second frame, the magnetic conductor being located in the housing, the cover plate being disposed on the housing to enclose the magnetic conductor together with the housing, and the coil being wound around an area where the housing corresponds to the magnetic conductor.

In some embodiments, the housing and the cover plate are made of plastic or a non-magnetic metal.

In some embodiments, the first frame has at least one first positioning structure, the second frame has at least one second positioning structure, and the first positioning structure is configured to be disposed in the second positioning structure to align the first frame with the second frame.

In some embodiments, the first positioning structure is a positioning protrusion, and the second positioning structure is a positioning hole.

Another aspect of the present disclosure provides a second chassis assembly. The chassis assembly includes a first frame, a second frame movably disposed on the first frame, at least one first connector and at least one second connector respectively disposed on the first frame and the second frame and located therebetween, at least one first magnetic element movably mounted to the first frame, the first magnetic element comprising at least one first magnet and at least one second magnet with different magnetic polarities, respectively, and at least one second magnetic element movably mounted to the second frame, the second magnetic element comprising at least one third magnet and at least one fourth magnet with different magnetic polarities, respectively, the second magnetic element being positioned to correspond to the first magnetic element. Movement of the first magnetic element or the second magnetic element selectively causes magnetic attraction or repulsion between the first magnetic element and the second magnetic element for engaging or disengaging the first connector and the second connector, respectively.

In some embodiments, the third magnet has a magnetic polarity opposite to that of the first magnet and as the same as that of the second magnet, the third magnet being configured to correspond to the first magnet or the second magnet.

In some embodiments, the chassis assembly further comprises at least one movable member that is located between the first frame and the second frame.

In some embodiments, the second magnetic element is disposed on the movable member.

In some embodiments, the movable member is rotatably disposed on the second frame.

In some embodiments, the movable member comprises a bearing seat, a handle, and a shaft.

In some embodiments, the bearing seat is connected to one end of the shaft and is located between the first frame and the second frame, and the second magnetic element is disposed on the bearing seat.

In some embodiments, the two first magnets, the two second magnets, the two third magnets, and the two fourth magnets are arranged along a circumferential line, respectively.

In some embodiments, the handle is connected to the other end of the shaft and is located on a side of the second frame away from the bearing seat.

In some embodiments, the shaft is rotatably disposed through the second frame.

In some embodiments, the first frame has at least one first positioning structure, the second frame has at least one second positioning structure, and the first positioning structure is configured to be disposed in the second positioning structure to align the first frame with the second frame.

In some embodiments, the first positioning structure is a positioning protrusion, and the second positioning structure is a positioning hole.

Still another aspects of the present disclosure provides a third chassis assembly. The chassis assembly includes a first frame, a second frame movably disposed on the first frame, at least one first connector and at least one second connector respectively disposed on the first frame and the second frame and located therebetween, at least one first magnetic element movably mounted to the first frame, the first magnetic element comprising at least one first magnet region and at least one second magnet region with different magnetic polarities, respectively, and at least one second magnetic element movably mounted to the second frame, the second magnetic element comprising at least one third magnet region and at least one fourth magnet region with different magnetic polarities, respectively, the second magnetic element being positioned to correspond to the first magnetic element. Movement of the first magnetic element or the second magnetic element selectively causes magnetic attraction or repulsion between the one first magnetic element and the second magnetic element for engaging or disengaging the first connector and the second connector, respectively.

This summary is provided to introduce a selection of concepts in a simplified form that are further described below in the Detailed Description. This summary is not intended to identify key features or essential features of the claimed subject matter, nor is it intended to be used to limit the scope of the claimed subject matter.

### BRIEF DESCRIPTION OF THE DRAWINGS

FIG. 1 is a perspective view of a chassis assembly apparatus in accordance with some embodiments of the present disclosure.
FIG. 2 is an exploded perspective view of the chassis assembly shown in FIG. 1.
FIG. 3 is a cross-sectional view illustrating the attraction between the magnetic element and the electromagnet assembly of the chassis assembly shown in FIG. 1.
FIG. 4 is a cross-sectional view illustrating the repulsion between the magnetic element and the electromagnet assembly of the chassis assembly shown in FIG. 1.
FIG. 5 is a perspective view of a chassis assembly in accordance with some embodiments of the present disclosure.
FIG. 6 is an exploded perspective view of the chassis assembly shown in FIG. 5.
FIG. 7 is an exploded view illustrating the attraction between a first magnetic element and a second magnetic element of the chassis assembly shown in FIG. 5.
FIG. 8 is a cross-sectional view illustrating the attraction between the first magnetic element and the second magnetic element of the chassis assembly shown in FIG. 5.
FIG. 9 is an exploded view illustrating the repulsion between the first magnetic element and the second magnetic element of the chassis assembly shown in FIG. 5.
FIG. 10 is a cross-sectional view illustrating the repulsion between the first magnetic element and the second magnetic element of the chassis assembly shown in FIG. 5.
FIG. 11 is a partially enlarged exploded view of a chassis assembly in accordance with some embodiments of the present disclosure.

### DETAILED DESCRIPTION

Various embodiments will be described in detail with reference to the drawings, wherein like reference numerals represent like parts and assemblies throughout the several views. Reference to various embodiments does not limit the scope of the claims attached hereto. Additionally, any examples set forth in this specification are not intended to be limiting and merely set forth some of the many possible embodiments for the appended claims.

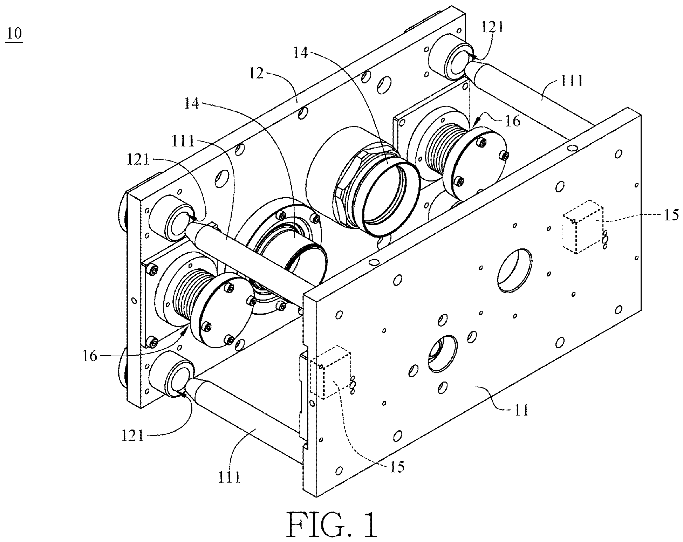

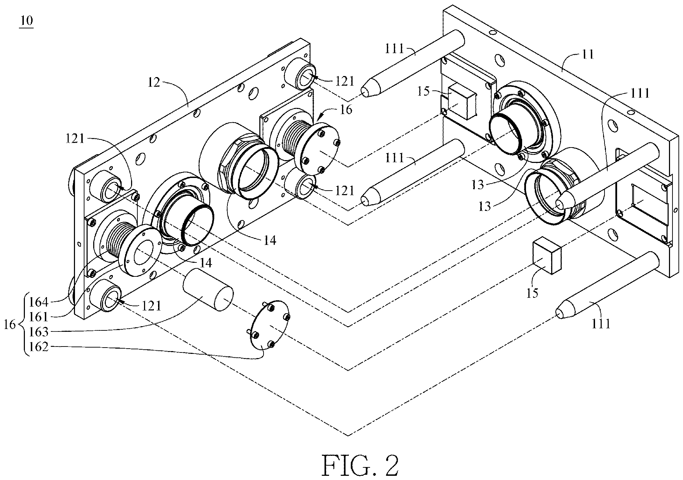

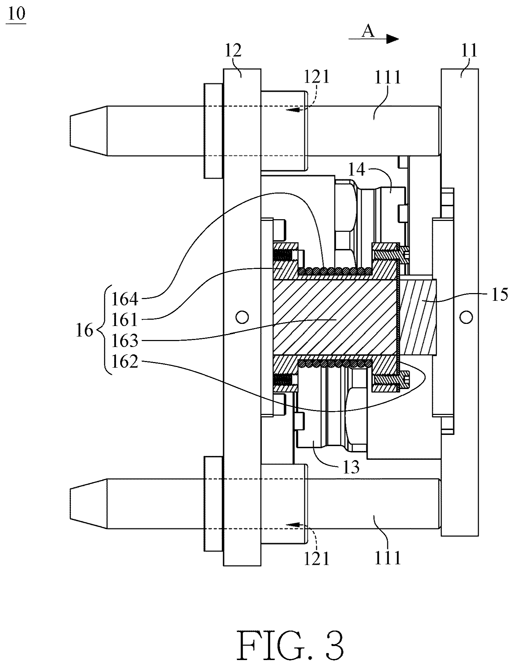

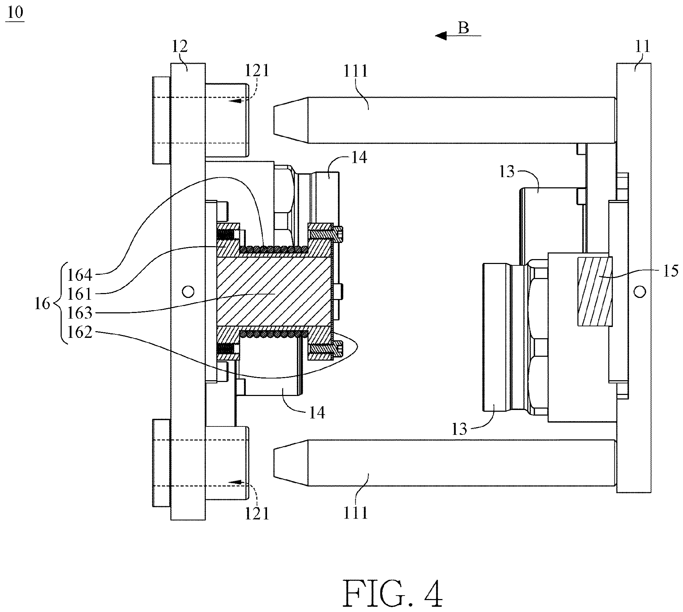

Referring to FIGS. 1-4, FIG. 1 is a perspective view of a chassis assembly apparatus in accordance with some embodiments of the present disclosure. FIG. 2 is an exploded perspective view of the chassis assembly shown in FIG. 1. FIG. 3 is a cross-sectional view illustrating the attraction between the magnetic element and the electromagnet assembly of the chassis assembly shown in FIG. 1. FIG. 4 is a cross-sectional view illustrating the repulsion between the magnetic element and the electromagnet assembly of the chassis assembly shown in FIG. 1.

In some embodiments, the chassis assembly apparatus 10 can be applied to a hotswappable coolant distribution unit or other suitable quick-release structures. The term "hotswappable" refers to the insertion or removal of system components when the system is powered on and operating, without interrupting normal operation. The chassis assembly apparatus 10 may be installed in a chassis (not shown). For example, the chassis can be a housing of a reservoir pumping unit (RPU), and the chassis assembly apparatus 10 is configured to be connected to a reservoir container (not shown) located within the chassis. In some examples, the reservoir container can be a water tank.

As an example shown in FIGS. 1-2, the chassis assembly apparatus 10 includes a first frame 11, a second frame 12, two first connectors 13, two second connectors 14, two magnetic elements 15, and two electromagnet assemblies 16. In some embodiments, the first frame 11 is a frame of a housing (not shown) of the chassis assembly apparatus 10. The second frame 12 is a frame of a fluid supply body (not shown) configured to contain coolant (not shown) in the chassis assembly apparatus 10. According to the embodiments, the second frame 12 is removably mounted to the first frame 11.

In some embodiments, the two first connectors 13 and the two second connectors 14 are fluid connectors. The first connectors 13 and the second connectors 14 are respectively disposed on the first frame 11 and the second frame 12, and are located between the first frame 11 and the second frame 12. The two first connectors 13 are configured to be in fluid communication with the two second connectors 14, respectively, so that the coolant can flow between the reservoir container and the fluid supply body.

In some embodiments, the two magnetic elements 15 are magnets disposed on the first frame 11 between the first frame 11 and the second frame 12. The two electromagnet assemblies 16 are disposed on the second frame 12 between the first frame 11 and the second frame 12. Each electromagnet assembly 16 corresponds to a respective magnetic element 15. However, the embodiments are not limited thereto. In other embodiments, the magnetic elements may be disposed on the second frame, and the electromagnet assemblies may be disposed on the first frame.

In some embodiments, each electromagnet assembly 16 includes a housing 161, a cover plate 162, a magnetic conductor 163, and a coil 164. The housing 161 is mounted on the second frame 12. The magnetic conductor 163 may be a ferromagnetic metal, such as iron, positioned within the housing 161. The cover plate 162 covers the housing 161 such that the housing 161 and the cover plate 162 together enclose the magnetic conductor 163. The coil 164 is wound around an area where the housing 161 corresponds with the magnetic conductor 163. However, the embodiments are not limited thereto. In other embodiments, the electromagnet assembly may include only the magnetic conductor and the coil, with the coil wound directly around the magnetic conductor.

In some embodiments, the housing 161 and the cover plate 162 may be made of plastic or a non-magnetic metal. By selectively energizing or de-energizing the two electromagnet assemblies 16, the magnetic elements 15 and the magnetic conductors 163 can be caused to attract or repel one another, resulting in mating or separation of the first connectors 13 and the second connectors 14.

In some embodiments, when the second frame 12 is secured to the first frame 11 via a quick-release structure (not shown), the quick-release structure may generate a return resistance of approximately 20 kilograms-force, for example. One magnetic element 15 and one electromagnet assembly 16 together form a pair. When the electromagnet assemblies 16 are unenergized and the magnetic elements 15 are positioned close to the electromagnet assemblies 16, each pair may generate approximately 30 kilograms-force of magnetic attraction, for example. Therefore, the two pairs together may generate a total magnetic attraction of approximately 60 kilograms-force, sufficient to offset the return resistance of the quick-release structure during assembly of the second frame 12 to the first frame 11. However, the embodiments are not limited thereto. In other embodiments, the total magnetic attraction between the magnetic elements 15 and the electromagnet assemblies 16 is only needed be equal to or exceed the return resistance of the quick-release structure.

In some embodiments, when the electromagnet assemblies 16 are energized and electrical power is applied, the resulting magnetic field may cause the electromagnet assemblies 16 to have the same magnetic polarity as the adjacent ends of the magnetic elements 15, thereby creating a repelling force that facilitates removal of the second frame 12 from the first frame 11. Accordingly, the second frame 12 can be attached and detached with more ease, enhancing the convenience of assembly and disassembly.

In some embodiments, the first frame 11 further includes multiple first positioning structures 111, and the second frame 12 further includes multiple second positioning structures 121. For example, the first positioning structures 111 can be positioning protrusions, and the second positioning structures 121 can be positioning holes. The first positioning structures 111 are configured to be inserted into the second positioning structures 121 to align the first frame 11 with the second frame 12. However, the embodiments are not limited thereto. In other embodiments, the first positioning structures may be positioning holes and the second positioning structures may be positioning protrusions.

In some embodiments, the chassis assembly apparatus 10 further includes multiple first latching structures (not shown) and multiple second latching structures (not shown). For example, the first latching structures and the second latching structures can be latch grooves and latch protrusions, respectively. But the embodiments are not limited thereto. In other embodiments, the first latching structures and the second latching structures can be latch protrusions and latch grooves, respectively. The first latching structures and the second latching structures are respectively disposed on the first frame 11 and the second frame 12. Upon the mating of the first connectors 13 and the second connectors 14, the first latching structures and the second latching structures can engage to enhance the security of the second frame 12 to the first frame 11.

In some embodiments, one of the two first connectors 13 and one of the two second connectors 14 may each include a flow-blocking member (not shown). When the first connectors 13 and the second connectors 14 are separated, the two flow-blocking members can respectively cover the openings of the corresponding connectors to prevent coolant leakage.

As an example shown in FIG. 3, when a user wants to assemble the second frame 12 with the first frame 11, the electromagnet assemblies 16 can be unenergized, and the second frame 12 can be installed in a direction A toward the first frame 11. Because the electromagnet assemblies 16 are unenergized and the coils do not generate magnetic field, the magnetic elements 15 and the magnetic conductors 163 are attracted to one another by magnetic force, thereby mating the first connectors 13 with the second connectors 14. Accordingly, the second frame 12 can be assembled with the first frame 11.

As an example shown in FIG.4, when a user wants to remove the second frame 12 from the first frame 11, the electromagnet assemblies 16 may be energized when electrical power is applied. At this point, the magnetic polarity at the ends of the electromagnet assemblies 16 adjacent to the magnetic elements 15 is the same as that of the ends of the magnetic elements 15 adjacent to the electromagnet assemblies 16, resulting in a repelling force that separates the first connectors 13 from the second connectors 14. In this way, the second frame 12 can be removed from the first frame 11 in direction B.

According to the present embodiments, the number of the first connectors 13, the second connectors 14, the magnetic elements 15, and the electromagnet assemblies 16 is two for each, but the embodiment are not limited thereto. In other embodiments, the number of the first connectors, the second connectors, the magnetic elements, and the electromagnet assemblies may be one, three, or more for each.

According to the present embodiments, when the two electromagnet assemblies are not energized and the magnetic elements and the electromagnet assemblies are close to one another, the magnetic attraction between the magnetic elements and the magnetic conductive members of the electromagnet assemblies can reduce the push-back resistance generated by the quick-release structure when the second frame is assembled to the first frame. Upon energization of the two electromagnet assemblies, they can, through the electromagnetic effect of current, generate magnetism equivalent to that of the magnetic elements, thereby repelling the magnetic elements. Therefore, the second frame can be removed from the first frame with less effort, thereby enhancing the efficiency of disassembly and assembly of the second frame.

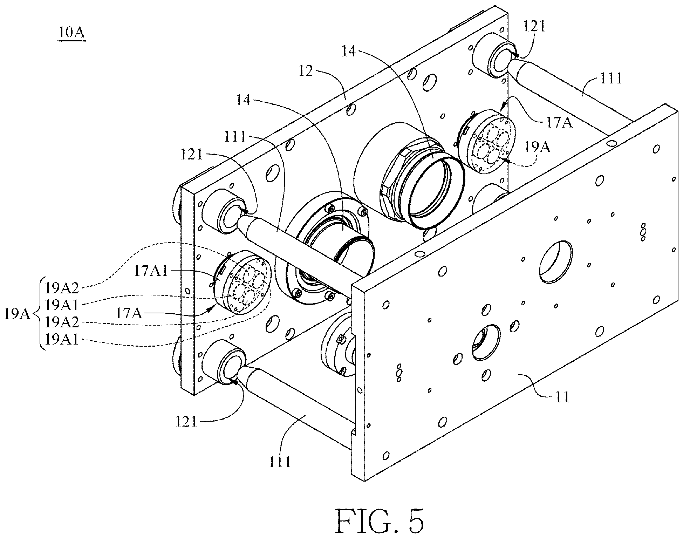

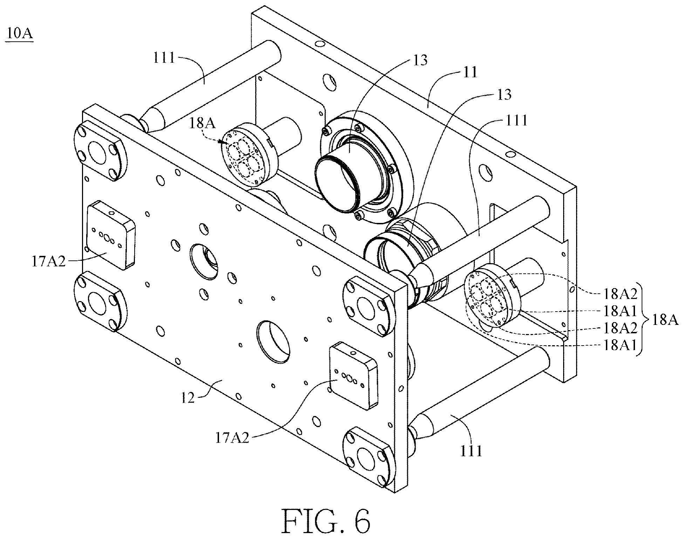

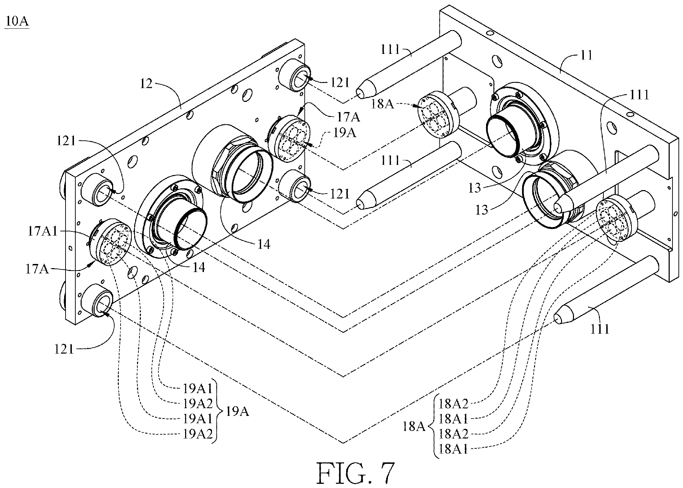

Referring to FIGS. 5-7, FIG. 5 is a perspective view of a chassis assembly in accordance with some embodiments of the present disclosure. FIG. 6 is an exploded perspective view of the chassis assembly shown in FIG. 5. FIG. 7 is an exploded view illustrating the attraction between a first magnetic element and a second magnetic element of the chassis assembly shown in FIG. 5. As an example shown in FIGS. 5-7, a chassis assembly apparatus 10A includes a first frame 11, a second frame 12, two first connectors 13, two second connectors 14, two movable members 17A, two first magnetic elements 18A, and two second magnetic elements 19A. In some embodiments, the second frame 12 is configured to be moveably disposed on the first frame 11.

In some embodiments, the two first connectors 13 and the two second connectors 14 can be fluid connectors, for example. The first connectors 13 and the second connectors 14 are respectively provided on the first frame 11 and the second frame 12 and positioned between the first frame 11 and the second frame 12. The two first connectors 13 are configured to respectively communicate with the two second connectors 14 so that cooling fluid may flow between a fluid reservoir and a fluid supply body.

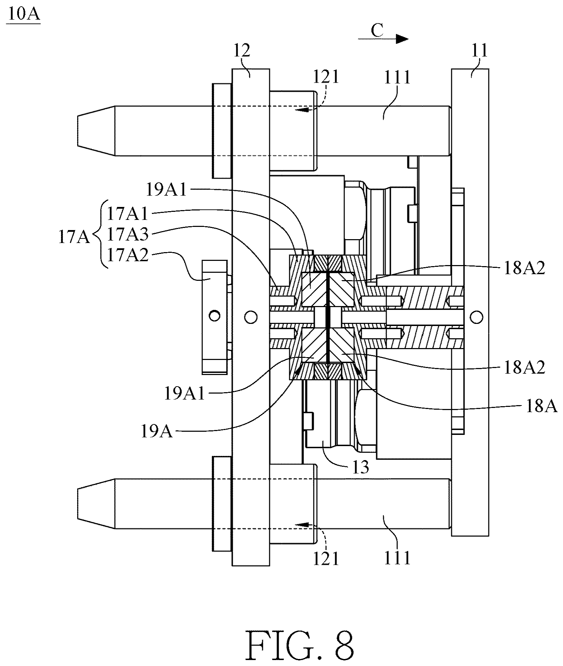

In some embodiments, the two movable members 17A are movably disposed on the second frame 12 and located at least partially between the first frame 11 and the second frame 12. Specifically, each movable member 17A includes a bearing seat 17A1, a handle 17A2, and a shaft 17A3 (shown in FIG. 8). The bearing seat 17A1 is connected to one end of the shaft 17A3 and located between the first frame 11 and the second frame 12. The handle 17A2 is connected to the other end of the shaft 17A3 and located on a side of the second frame 12 opposite to the bearing seat 17A1. The shaft 17A3 is rotatably disposed through the second frame 12, allowing the two movable members 17A to be rotatably mounted to the second frame 12.

In some embodiments, the two first magnetic elements 18A are disposed on the first frame 11. Each first magnetic element 18A includes two first magnets 18A1 and two second magnets 18A2. For example, the two first magnets 18A1 and the two second magnets 18A2 can be permanent magnets, with the magnetic polarity of the first magnets 18A1 differing from that of the second magnets 18A2. The first magnets 18A1 and the second magnets 18A2 may be arranged alternately along a circumferential line.

In some embodiments, the two second magnetic elements 19A are respectively disposed on the two bearing seats 17A1. Each second magnetic element 19A includes two third magnets 19A1 and two fourth magnets 19A2. For example, the third magnets 19A1 and the fourth magnets 19A2 can be permanent magnets, with the magnetic polarity of the fourth magnets 19A2 differing from that of the third magnets 19A1. Additionally, the magnetic polarity of the third magnets 19A1 may differ from that of the first magnets 18A1 and be the same as that of the second magnets 18A2, and the magnetic polarity of the fourth magnets 19A2 may be the same as that of the first magnets 18A1 and differ from that of the second magnets 18A2. The third magnets 19A1 and the fourth magnets 19A2 may be arranged alternately along a circumferential line.

In some embodiments, by actuating the two movable members 17A, the second magnetic elements 19A can be rotated relative to the first magnetic elements 18A by mounting them on the movable members 17A that are rotatable relative to the first frame 11. Accordingly, the two third magnets 19A1 are positioned to correspond to the two first magnets 18A1, and the two fourth magnets 19A2 are positioned to correspond to the two second magnets 18A2; so the first magnetic elements 18A and the second magnetic elements 19A can attract one another. Alternatively, the two third magnets 19A1 may be positioned to correspond to the two second magnets 18A2, and the two fourth magnets 19A2 may be positioned to correspond to the two first magnets 18A1, so that the first magnetic elements 18A and the second magnetic elements 19A repel one another.

In some embodiments, when the second frame 12 is mounted to the first frame 11 and secured thereto by a quick-release structure (not shown), the quick-release structure may generate a return resistance of 20 kilograms, for example. Because the present chassis assembly apparatus 10A is provided with two first magnetic elements 18A and two second magnetic elements 19A, and a single pair of the first magnetic element 18A and the second magnetic element 19A can generate such as 30 kilograms of magnetic attraction, the two pairs together can generate a total magnetic attraction of approximately 60 kilograms. Therefore, the magnetic attraction between the first magnetic elements 18A and the second magnetic elements 19A can be used to reduce the return force generated by the quick-release structure while coupling the second frame 12 to the first frame 11. Additionally, when the movable members 17A are rotated, the first magnetic elements 18A and the second magnetic elements 19A may repel one another, thereby allowing the second frame 12 to be removed from the first frame 11 with less force. Accordingly, the second frame 12 can be assembled and disassembled with more ease, enhancing the convenience of those processes.

In some embodiments, the movable members 17A can be alternatively disposed corresponding to the first magnetic elements 18A, allowing the first magnetic elements 18A to rotate relative to the second magnetic elements 19A. When the movable members 17A are rotated, the first magnetic elements 18A serve as the active members and the second magnetic elements 19A serve as secured members The engagement or disengagement between the first magnetic elements 18A and the second magnetic elements 19A is achieved by rotating the first magnetic elements 18A. Therefore, the first magnetic elements 18A are rotatable relative to the second magnetic elements 19A because they are mounted on the movable members 17A that can be rotated relative to the second frame 12.

In some embodiments, the first frame 11 further includes a plurality of first positioning structures 111, and the second frame 12 further includes a plurality of second positioning structures 121. For example, the first positioning structures 111 can be positioning protrusions, and the second positioning structures 121 can be positioning holes. The first positioning structures 111 are configured to be inserted into the second positioning structures 121 to align the first frame 11 with the second frame 12. However, the embodiments are not limited thereto. In other embodiments, the first positioning structures may be positioning holes and the second positioning structures may be positioning protrusions.

According to the present embodiments, the number of first magnetic elements 18A and the number of second magnetic elements 19A are two for each, but the embodiments are not limited thereto. In other embodiments, the number of first magnetic elements and the number of second magnetic elements may be only one for each or may be three or more for each.

According to the present embodiments, the number of first magnets 18A1, the number of second magnets 18A2, the number of third magnets 19A1, and the number of fourth magnets 19A2 are two for each, but the embodiments are not limited thereto. In other embodiments, the number of first magnets, the number of second magnets, the number of third magnets, and the number of fourth magnets may be only one for each or may be three or more for each. The first magnetic element may only include the first magnets without including the second magnets; the second magnetic element may only include the third magnets without including the fourth magnets.

According to the present embodiments, the first magnetic elements 18A are disposed on the first frame 11, and the second magnetic elements 19A are disposed on the bearing seats 17A1, but the embodiments are not limited thereto. In other embodiments, the first magnetic elements may be disposed on the bearing seats, and the second magnetic elements may be disposed on the first frame.

According to the present embodiments, the two movable members 17A are rotatably disposed on the second frame 12, the two first magnets 18A1 and the two second magnets 18A2 are arranged alternately along a circumferential line, and the two third magnets 19A1 and the two fourth magnets 19A2 are arranged alternately along a circumferential line. However, the embodiments are not limited thereto. In other embodiments, the two movable members may be slidably disposed on the second frame, the two first magnets and the two second magnets may be arranged alternately along a straight line, and the two third magnets and the two fourth magnets may be arranged alternately along a straight line.

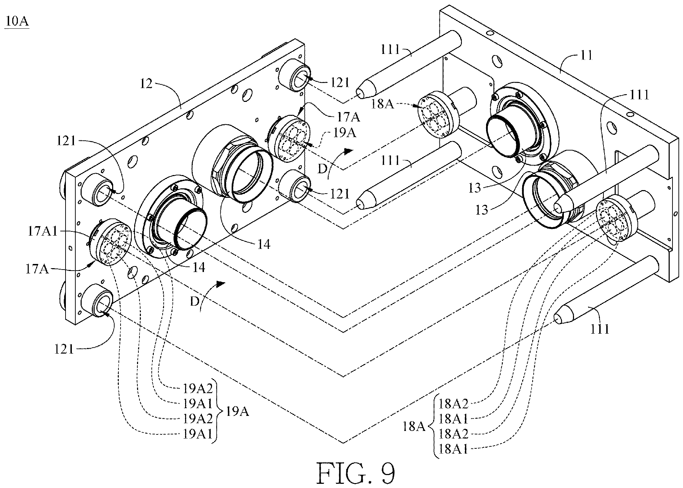

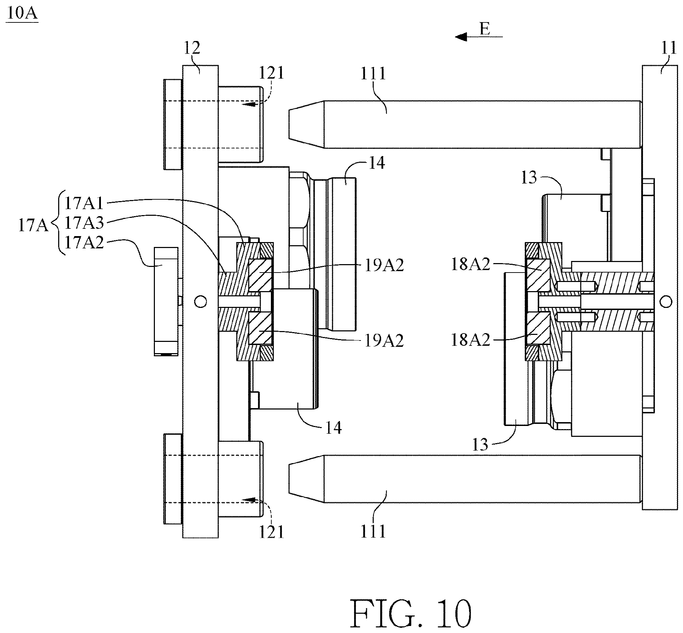

Referring to FIGS. 8-10, FIG. 8 is a cross-sectional view illustrating the attraction between the first magnetic element and the second magnetic element of the chassis assembly shown in FIG. 5. FIG. 9 is an exploded view illustrating the repulsion between the first magnetic element and the second magnetic element of the chassis assembly shown in FIG. 5. FIG. 10 is a cross-sectional view illustrating the repulsion between the first magnetic element and the second magnetic element of the chassis assembly shown in FIG. 5.

In some embodiments, when a user wants to assemble the second frame 12 to the first frame 11, the second frame 12 can be mounted to the first frame 11 in direction C. At this point, the first magnet 18A1 corresponds to the third magnet 19A1, and the second magnet 18A2 corresponds to the fourth magnet 19A2. Accordingly, the first magnetic element 18A and the second magnetic element 19A are attracted to one another through magnetic attraction, allowing the first connector 13 to mate with the second connector 14. Therefore, the second frame 12 can be assembled with the first frame 11.

In some embodiments, when a user wants to remove the second frame 12 from the first frame 11, a handle 17A2 of a movable member 17A may be rotated in direction D, thereby driving the second magnetic element 19A to rotate in direction D. At this point, the first magnet 18A1 corresponds to the fourth magnet 19A2, and the second magnet 18A2 corresponds to the third magnet 19A1. Accordingly, the first magnetic element 18A and the second magnetic element 19A repel one another, separating the first connector 13 from the second connector 14. Therefore, the second frame 12 can be removed from the first frame 11 in direction E.

According to the present embodiments, the first magnet 18A1, the second magnet 18A2, the third magnet 19A1, and the fourth magnet 19A2 are permanent magnets, but the embodiments are not limited thereto. In other embodiments, those magnets may not be permanent magnets.

According to the present embodiments, magnetic attraction between the first magnetic elements and the second magnetic elements can reduce the push-back resistance generated by the quick-release structure during assembly of the second frame with the first frame. When the movable members are rotated, the two first magnetic elements repel the two second magnetic elements, allowing the second frame to be removed from the first frame with less effort, resulting in easier disassembly and assembly of the second frame.

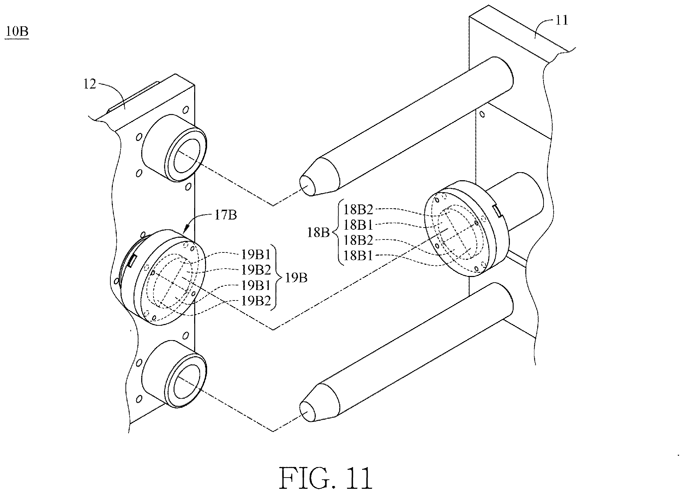

Referring to FIG. 11, FIG. 11 is a partially enlarged exploded view of a chassis assembly in accordance with some embodiments of the present disclosure. The chassis assembly apparatus 10B of FIG. 11 is similar to the chassis assembly apparatus 10A of FIG. 5. Therefore, only the differences will be described below, and the similarities will not be repeated.

In some embodiments, the first magnetic element 18B is not a permanent magnet; instead, it includes magnetic regions generated, for example, through magnetization. Specifically, the first magnetic element 18B includes two first magnetic regions 18B1 and two second magnetic regions 18B2. The magnetic properties of the first magnetic regions 18B1 are different from those of the second magnetic regions 18B2. In some examples, the first magnetic regions 18B1 and the second magnetic regions 18B2 are arranged alternately along a circumferential line.

In some embodiments, the second magnetic element 19B is also not a permanent magnet; instead, it includes magnetic regions generated, for example, through magnetization. Specifically, the second magnetic element 19B includes two third magnetic regions 19B1 and two fourth magnetic regions 19B2. The magnetic properties of the third magnetic regions 19B1 are different from those of the fourth magnetic regions 19B2. Additionally, the magnetic properties of the third magnetic regions 19B1 differ from those of the first magnetic regions 18B1 and align with those of the second magnetic regions 18B2, while the magnetic properties of the fourth magnetic regions 19B2 align with those of the first magnetic regions 18B1 and differ from those of the second magnetic regions 18B2. In some examples, the third magnetic regions 19B1 and the fourth magnetic regions 19B2 are arranged alternately along a circumferential line.

In some embodiments, through the movement of two movable members 17B, the two third magnetic regions 19B1 can respectively correspond to the two first magnetic regions 18B1, and the two fourth magnetic regions 19B2 can respectively correspond to the two second magnetic regions 18B2; so the first magnetic regions 18B1 and the second magnetic regions 18B2 attract one another. Alternatively, the two third magnetic regions 19B1 can respectively correspond to the two second magnetic regions 18B2, and the two fourth magnetic regions 19B2 can respectively correspond to the two first magnetic regions 18B1; so the first magnetic element 18B and the second magnetic element 19B repel one another.

According to the present embodiments, the quantities of the first magnetic regions 18B1, second magnetic regions 18B2, third magnetic regions 19B1, and fourth magnetic regions 19B2 are two for each, but the embodiments are not limited thereto. In other embodiments, the quantity of the first magnetic regions, second magnetic regions, third magnetic regions, and fourth magnetic regions may be one for each or may be three or more for each. Alternatively, the first magnetic element may include only first magnetic regions without second magnetic regions; or, the second magnetic element may include only third magnetic regions without fourth magnetic regions.

According to the present embodiments, the second magnetic element 19B can be rotated relative to the first magnetic element 18B by mounting it on movable members 17B that are rotatable relative to the first frame 11, but the embodiments are not limited thereto. In other embodiments, the first magnetic element 18B may be rotated relative to the second magnetic element 19B.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope of theappended claims. Of course, the disclosed embodiments are merely exemplary embodiments and that various modifications can be made without departing from the scope of the claims. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of' the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A chassis assembly (10), comprising:
a first frame (11);
a second frame (12) movably disposed on the first frame (11);
at least one first connector (13) and at least one second connector (14) respectively disposed on the first frame (11) and the second frame (12) and located therebetween;
at least one magnetic element (15) located between the first frame (11) and the second frame (12); and
at least one electromagnet assembly (16) located between the first frame (11) and the second frame (12) that corresponds to the magnetic element (15), the electromagnet assembly (16) having a magnetic conductor (163) and a coil (164) that is wound around the magnetic conductor (163);
wherein:
when the electromagnet assembly (16) is in an unenergized state, the at least one magnetic element (15) and the magnetic conductor (163) attract one another to cause the first connector (13) and the second connector (14) to mate, and
when the electromagnet assembly (16) is in an energized state, the magnetic element (15) and the magnetic conductor (163) repel one another to cause the first connector (13) and the second connector (14) to separate.

2. The chassis assembly (10) of claim 1, wherein the magnetic element (15) is disposed on the first frame (11), and the electromagnet assembly (16) is disposed on the second frame (12).

3. The chassis assembly (10) of claim 2, wherein the electromagnet assembly (16) further comprises a housing (161) and a cover plate (162), the housing (161) being disposed on the second frame (12), the magnetic conductor (163) being located in the housing (161), the cover plate (162) being disposed on the housing (161) to enclose the magnetic conductor (163) together with the housing (161), and the coil (164) being wound around an area where the housing (161) corresponds to the magnetic conductor (163).

4. The chassis assembly (10) of claim 3, wherein the housing (161) and the cover plate (162) are made of plastic or a non-magnetic metal.

5. The chassis assembly (10) of claim 1, wherein the first frame (11) has at least one first positioning structure (111), the second frame (12) has at least one second positioning structure (121), and the first positioning structure (111) is configured to be disposed in the second positioning structure (121) to align the first frame (11) with the second frame (12).

6. The chassis assembly (10) of claim 5, wherein the first positioning structure (111) is a positioning protrusion, and the second positioning structure (121) is a positioning hole.

7. A chassis assembly (10), comprising:
a first frame (11);
a second frame (12) movably disposed on the first frame (11);
at least one first connector (13) and at least one second connector (14) respectively disposed on the first frame (11) and the second frame (12) and located therebetween;
at least one first magnetic element (18) movably mounted to the first frame (11), the first magnetic element (18) comprising at least one first magnet (18A1) and at least one second magnet (18A2) with different magnetic polarities, respectively; and
at least one second magnetic element (19) movably mounted to the second frame (12), the second magnetic element (19) comprising at least one third magnet (19A1) and at least one fourth magnet (19A2) with different magnetic polarities, respectively, the second magnetic element (19) being positioned to correspond to the first magnetic element (18);
wherein movement of the first magnetic element (18) or the second magnetic element (19) selectively causes magnetic attraction or repulsion between the first magnetic element (18) and the second magnetic element (19) for engaging or disengaging the first connector (13) and the second connector (14), respectively.

8. The chassis assembly (10) of claim 7, wherein the third magnet (191) has a magnetic polarity opposite to that of the first magnet (18A1) and as the same as that of the second magnet (18A2), the third magnet (19A1) being configured to correspond to the first magnet (18A1) or the second magnet (18A2).

9. The chassis assembly (10) of claim 7, further comprises at least one movable member (17) that is located between the first frame (11) and the second frame (12).

10. The chassis assembly (10) of claim 9, wherein the second magnetic element (19) is disposed on the movable member (17).

11. The chassis assembly (10) of claim 9, wherein the movable member (17) is rotatably disposed on the second frame (12).

12. The chassis assembly (10) of claim 9, wherein the movable member (17) comprises a bearing seat (171), a handle (172), and a shaft (173).

13. The chassis assembly (10) of claim 12, wherein the bearing seat (171) is connected to one end of the shaft (173) and is located between the first frame (11) and the second frame (12), and the second magnetic element (19) is disposed on the bearing seat (171).

14. The chassis assembly (10) of claim 13, wherein the two first magnets (18A1), the two second magnets (18A2), the two third magnets (19A1), and the two fourth magnets (192) are arranged along a circumferential line, respectively.

15. The chassis assembly (10) of claim 12, wherein the handle (172) is connected to the other end of the shaft (173) and is located on a side of the second frame (12) away from the bearing seat (171).

16. The chassis assembly (10) of claim 12, wherein the shaft (173) is rotatably disposed through the second frame (12).

17. The chassis assembly (10) of claim 7, wherein the first frame (11) has at least one first positioning structure (111), the second frame (12) has at least one second positioning structure (121), and the first positioning structure (111) is configured to be disposed in the second positioning structure (121) to align the first frame (11) with the second frame (12).

18. The chassis assembly (10) of claim 17, wherein the first positioning structure (111) is a positioning protrusion, and the second positioning structure (121) is a positioning hole.

19. A chassis assembly (10), comprising:
a first frame (11);
a second frame (12) movably disposed on the first frame (11);
at least one first connector (13) and at least one second connector (14) respectively disposed on the first frame (11) and the second frame (12) and located therebetween;
at least one first magnetic element (18) movably mounted to the first frame (11), the first magnetic element (18) comprising at least one first magnet region (18B1) and at least one second magnet region (18B2) with different magnetic polarities, respectively; and
at least one second magnetic element (19) movably mounted to the second frame (12), the second magnetic element (19) comprising at least one third magnet region (19B1) and at least one fourth magnet region (19B2) with different magnetic polarities, respectively, the second magnetic element (19) being positioned to correspond to the first magnetic element (18);
wherein movement of the first magnetic element (18) or the second magnetic element (19) selectively causes magnetic attraction or repulsion between the one first magnetic element (18) and the second magnetic element (19) for engaging or disengaging the first connector (13) and the second connector (14), respectively.

20. The chassis assembly (10) of claim 19, further comprises at least one movable member (17) that is at least partially located between the first frame (11) and the second frame (12) and is rotatably disposed on the second frame (12).
